(19) Europäisches Patentamt

European Patent Office

Office européen des brevets

(11) Publication number: **0 117 434**
**A1**

(12) # EUROPEAN PATENT APPLICATION

(21) Application number: 84100776.8

(51) Int. Cl.³: **H 01 L 23/56**, H 01 L 25/00

(22) Date of filing: **25.01.84**

(30) Priority: **28.01.83 US 461778**

(71) Applicant: **Microwave Semiconductor Corp., 100 School House Road, Somerset New Jersey (US)**

(43) Date of publication of application: **05.09.84 Bulletin 84/36**

(72) Inventor: **Wallace, Philipp W., 150 B Pleasant View Drive, Piscataway, N.J. 08854 (US)**

(74) Representative: **Mehl, Ernst, Dipl.-Ing., Postfach 22 01 76, D-8000 München 22 (DE)**

(84) Designated Contracting States: **DE FR GB**

(54) **Hybrid microwave subsystem.**

(57) A hybrid micro-wave subsystem includes a high thermally conductive dielectric substrate having wrapped around a thin-film metalized ground plane such that a center area on the top surface is left exposed. Electrode bonding pads are arranged within this center area to receive respective electrodes of a flip-mounted transistor device. A thin-film matching network is mounted onto the center area and is connected to respective ones of the bonding pads. Discrete components are directly mounted onto the top surface for connection with the transistor device.

## BACKGROUND OF THE INVENTION

The invention is related to microwave devices and more particularly to a hybrid microwave subsystem to be connected to a microwave transmission line.

In the following a microwave subsystem may be understood as an active electronic device designed to be connected to a microwave transmission line, examples for such devices are power amplifiers, receivers and active filters, etc.

Such subsystems are conventionally implemented by utilizing discrete elements. This design has the disadvantage of being rather voluminous and even more, has the drawback of relatively long electrical connectors between the various components resulting in parasitic reactances which limit the performance characteristics of the circuit. On the other hand, the progress in semiconductor technology has made it possible to integrate various components onto one chip. Therefore, two groups of approaches are presently known for implementing such microwave subsystems. One group still utilizes packaged discrete transistors which are then assembled into circuits. The other group represents monolithic approaches in gallium arsenide (Ga As) technology.

A plurality of variations to the discrete approach are known. U.S. Patent 3,414,968 discloses a method of assembly of a silicone type planar power transistor for incorporation into a micro circuit. For improving heat dissipation a copper plate forming a heat sink bears a beryllia substrate and the planar transistor is flip-mounted onto the top surface of the substrate. The electrodes of the transistor are bonded to glass or other suitable electrically insulated materials of high thermal conductivity for connection into a circuit.

Another design with upright mounting of the transistor pellet and bond wire connections is described in U.S. Patent 3,946,428. The transistor is mounted on an auxiliary metal stud with at least one electrode connected to the stud. The object is to yield improved heat dissipation, and a shortening of bond wires aiming at lower parasitic inductances and a shield effect for the electrical field for decreasing the mutual effect of connector leads in view of leakage current between source and drain of the transistor.

A variation of this approach is disclosed in U.S. Patent 4,067,040 which is related to a semiconductor device with efficient heat dissipation. A semiconductor support member is formed of an electrically insulating but thermally conductive material having a projecting portion on the top surface. A first conducting layer extends along the surfaces of this support member from the bottom to the projecting portion. An insulating wall member for installing terminals is disposed on the top surface of the semiconductor support member in areas around the projecting portion. A second conducting layer is formed on the top end face of the wall member, and a hollow portion is provided in the wall member below the second conducting layer.

It is conceivable that these discrete approaches also allow for some amount of circuit matching by utilizing the bond wires as matching elements; thereby leading to an internally matched device.

The monolithic approach entails printing circuit and device implemented on one gallium arsenide (Ga As) chip using the same technique as known for silicon integrated circuits. The known state of the art of integrated semiconductor technology allows for implementing an entire subsystem on one chip. This approach has the advantage of a significant size reduction. This advantage, however, comes together with high costs since the restraint of any monolithic design is that a flaw anywhere on the chip renders the entire circuit unusable. Another restraint of a monolithic design in Ga As technology results from the fact that this semiconductor material has a relatively low thermal conductivity which makes it impractical to use with higher power devices.

0117434

8∂ PT401E

## SUMMARY OF THE INVENTION

It is therefore, a general object of the present invention to provide an improved microwave subsystem of a design which allows for a substantial size reduction being comparable to a monolithic approach without its limitation of a reduced yield.

A further object of the present invention is to provide such a microwave subsystem with efficient heat sinking capabilities enabling the use of the same in high power devices.

Another object of the present invention is to provide such an improved microwave subsystem incorporating a design concept which is suitable for a mass production mode at low cost by employing well established semiconductor fabrication and testing techniques.

Still another object of the present invention is to provide such an improved microwave subsystem based upon a design concept which is flexible enough to allow for implementing a variety of actual circuits without expensive changes for each application mode.

These objects, as well as other objects which will become more aparent from the description that follows are achieved by a hybrid microwave subsystem for direct connection to a microwave transmission line, which system includes a dielectric substrate of high thermal conductivity and having plane bottom and top surfaces and a thin-film metalized ground plane covering the bottom surface and being wrapped around the substrate leaving a center area on the top surface exposed. Electrode bonding pads are mounted onto the top surface and are arranged within the open center area. A transistor device having coplanar electrodes is flip-mounted onto the top surface in alignment with the electrode bonding pads. A
thin-film matching network is arranged in said open center area and
is connected to respective ones of the bonding pads. Furthermore, a
discrete component is mounted onto the top surface for connection
with the transistor device.

This system design has a series of advantages over standard hybrid
technology or monolithic approaches utilizing integrated circuit
technology by combining the useful features of both types of
approaches in a unique manner. Well established production
techniques are used, such as flip-mounting of a transistor pellet
onto an auxiliary substrate which eliminates assembly registration
errors. A small physical size of the assembled subsystem is
achieved which is comparable to an integrated circuit, makes
efficient use of expensive semiconductor material which nevertheless
allows for a good thermal conductivity. On the other hand, the
draw-back of a monolithic approach with limited yield is avoided
since high quality production components such as diodes, capacitors,
transistors, etc., can be fully tested prior to assembling the
same. Furthermore, the design concept is flexible enough to allow
for quickly implementing such a subsystem by utilizing one in the
same basic design concept. A similar cost reduction furthermore, is
achieved by a large reduction in assembly labor as compared to
standard hybrid technology.

In accordance with preferred embodiments of the invention, gallium
arsenide field effect transistors are employed and the substrate is
composed of beryllium oxide forming together with the metalized
ground plane an efficient heat sink for the field effect
transistor. By using beryllium oxide as the dielectric substrate
material and by flip-mounting the transistor pellets onto the
substrate a sufficiently high thermal flow is achieved which allows for high power application not to be reached by known monolithic approaches and various discrete solutions. In addition, beryllium oxide has the advantage of having substantially the same coefficent of thermal expansion as gallium arsenide; a significant factor which reduces heat tensions between the assembled elements and allows for a wide temperature range in use of the device. It is essential for the incorporation of the hybrid subsystem into a microwave transmission line which is preferably a microstripline that the actual ground plane, in fact, is mounted to the bottom of the substrate. However, since this ground plane is wrapped around to the top surface of the substrate a plurality of lumped elements can be assembled to the circuit in close spatial relationship to an active transistor device. In addition, matching networks formed of the correspondingly shaped leads can either be commonly formed together with respective bonding pads of the active device or can be spaced apart and insulated from such pads by a gap. The gap can be bridged by a bond wire which may be coiled to build a series inductor with or without insertion of a capacitor as another lumped element.

In summary, the practical tests have proven that it is possible without undue impact to utilize a design with a ground plane wrapped around an auxiliary substrate to construct a board which constitutes a base for unpackaged semiconductor devices and lumped elements, as well as yielding a hybrid microwave subsystem assembled onto one substrate and packaged for assembly.

0117434

## BRIEF DESCRIPTION OF THE DRAWINGS

A better understanding of the invention may be had by reference to the following description of preferred embodiments in conjunction with the accompanying drawings in which:

Fig. 1 is a perspective view of the basic structure of a hybrid microwave subsystem according to the present invention comprising a field effect transistor designed for being flip-mounted onto a substrate;

Fig. 2 is another perspective view of such a hybrid microwave subsystem comprising an amplifier stage, including internally arranged matching networks and assembled lumped elements;

Fig. 3 is a block diagram representing an equivalent circuit diagram of the hybrid microwave subsystem shown in Fig. 2;

Fig. 4 is a top view of another embodiment comprising a cascaded 2-stage amplifier including bias networks and matching networks; and

Fig. 5 is a block diagram representing the equivalent circuit diagram of the hybrid microwave subsystem shown in Fig. 4.

## DESCRIPTION OF THE PREFERRED EMBODIMENT

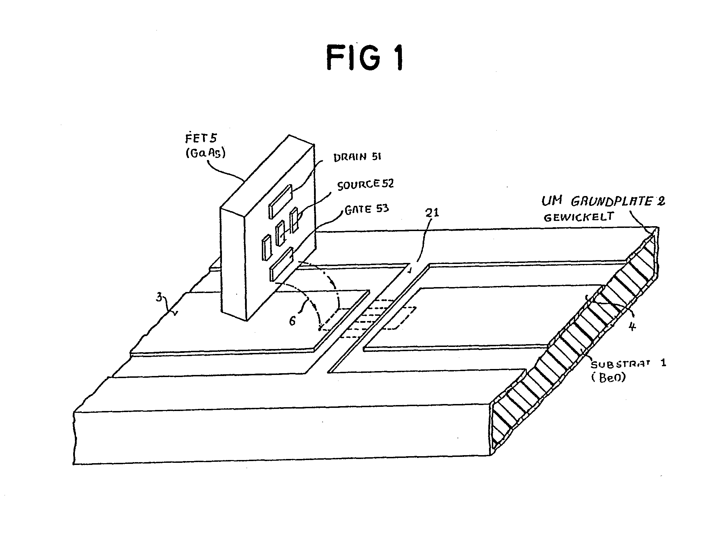

Representing schematically the basic structure of a hybrid circuit, Fig. 1 shows a three-dimensional sectional view of a device bonding area. A substrate 1 of beryllium oxide (BeO) has a bottom surface bearing a ground plane 2 which is wrapped around the substrate 1 to cover also substantial parts of the substrate's top surface. Between the two lateral rims of the ground plate 21 on the top surface and connected to the same there is arranged a source bonding pad 21 extending perpendicular to the center axis of the substrate 1. Adjacent to this source bonding pad there are provided two metal conductors 3 and 4, running along the center axis of the substrate 1 and forming a gate bonding pad and a drain bonding pad, respectively.

Fig. 1 shows schematically a field effect transistor device having a drain pad 51, source pads 52 and a gate pad 53 schematically indicated on the bottom surface of the field effect device 5. The field effect device 5 is designated to be flip-mounted on the top surface of the substrate 1, as schematically indicated by arrows 6 such that the electrode pads of the field effect device are in alignment with the respective bonding pads mounted onto the top surface of the substrate 1. This arrangement constitutes a coplanar structure with high thermal conductivity wherein the substrate 1 and the ground plane 2 plated onto it form an efficient heat sink for the field effect transistor device 5.

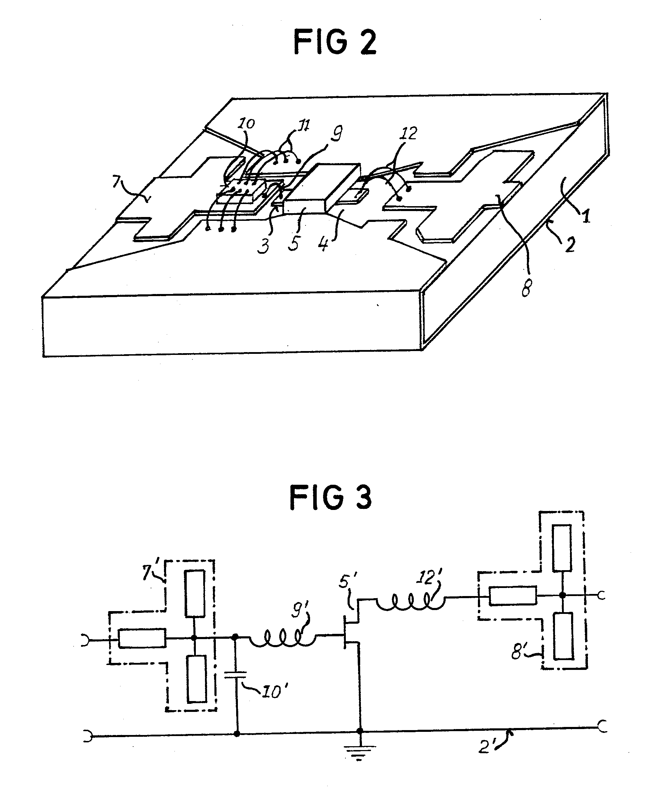

The application of this basic structure of a field effect transistor device flip-mounted onto a dielectric substrate in a hybrid circuit is represented in the three-dimensional view of Fig. 2. The center top section of this drawing corresponds to the arrangement shown in Fig. 1 with the only exception that the field effect transistor device 5 is already mounted onto the corresponding bonding pads 3 and 4 and the ground plane 2, respectively.

In addition, several discrete elements are directly mounted onto
this board thereby constructing a hybrid circuit which may comprise
a complete stage of a power amplifier in this example. On both
sides of the field effect transistor device 5 there are arranged
respective matching networks 7,8 formed of conductors aligned with
the center axis of the structure and having open stubs. The outer
ends of each network are adapted to be connected to a microstrip
transmission line, not shown. The inner ends face a respective one
of the gate bonding pad 3 and the drain bonding pad 4 with a gap
formed in between.

The matching network 7 comprises an input matching network and is
connected to the gate bonding pad 3 by a bonded wire 9 which may be
coiled to establish a lumped series inductor. A capacitor 10 is
mounted onto the input matching network 7 and is connected to the
wrapped around ground plane 2 by further bonded wires 11. Thus, the
capacitor 10, forms a shunt capacitor and comprises together with
the series inductor 9 a bias network for the field effect transistor
device 5. Similarly, the drain bonding pad 4 is connected to the
other matching network 8 associated with the output side by a
further bond wire 12 which form a second series inductor. It is
evident that the ground plane 2 being wrapped around to the top
surface of the substrate 1 allows for a direct mounting of various
lumped elements on the top surface immediately adjacent to the
active device in a space saving manner. This reduces the size of
such a subsystem as compared to a conventional discrete design by a
substantial factor and avoids the influence of parasitic reactances
of longer bond wires of such a conventional system.

The equivalent circuit diagram of the hybrid circuit to be described
in conjunction with Fig. 2 is represented in the schematic shown in
Fig. 3. The correlation of the elements is indicated by corresponding reference symbols, i.e., the ground plane 2 of the hybrid circuit is represented in Fig. 3 by a line 2' connected to ground. The two matching networks 7 and 8 are represented by transmission line networks 7' and 8', respectively, composed of through-connected and open end transmission lines. The shunt capacitor 10' is arranged between the grounded line 2' and the transmission line circuit 7'. The field effect transistor (FET) device 5 is represented by FET 5' having a source connected to the ground line 2', a gate constituting the input and a drain forming the output of the field effect transistor device. The gate is connected to the input matching network 7' across an inductor 9' which represents the series inductor 9. Similarly, a second inductor 12' corresponding to the second series inductor 12 through-connects the drain of the FET 5' to the second transmission line network 8'.

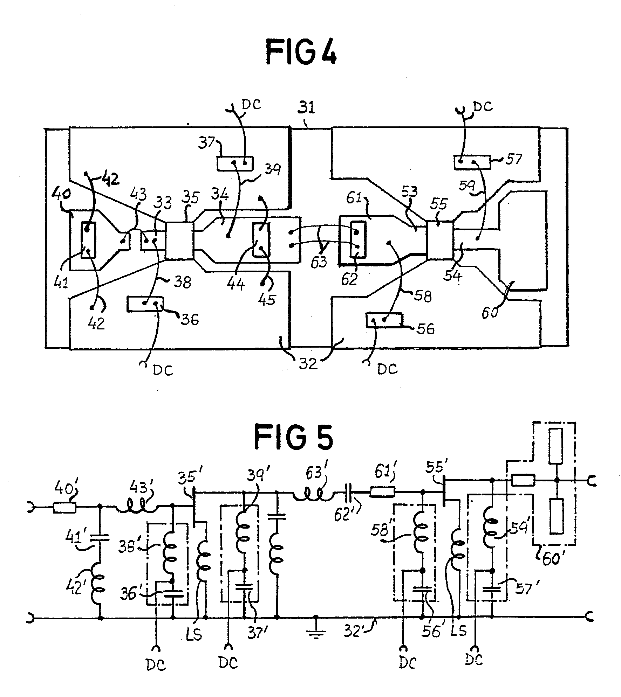

Representing the flexibility of the design concept, a second embodiment of the invention is represented in Fig. 4 showing a hybrid circuit constituting a two-stage amplifier. The equivalent circuit diagram of this cascaded amplifier is shown in Fig. 5. Again, a dielectric substrate 31 of beryllium oxide having wrapped around the ground plane 32 which is represented in Fig. 5 by the grounded line 32'. The first amplifier stage includes another field effect transistor device 35 as active element which is flip-mounted onto the substrate 31 and the wrapped around ground plane 32. Gate and drain of this transistor are bonded to a gate bonding pad 33 and a drain bonding bond 34, respectively. This transistor is designated in the equivalent circuit diagram of Fig. 5 by reference numeral 35'. The equivalent circuit diagram of Fig. 5 shows more accurately than Fig. 3 an inductance LS connecting the source to the ground. This element represents a small parasitic inductance which is caused by the fact that the true ground plane 32 is plated onto the bottom surface of the substrate 31.

As illustrated in Fig. 5, radio frequency (RF) chokes, are arranged between each the gate and the drain of the field effect transistor device 35 and the ground line 22'. Each RF choke is composed of a series circuit of an inductance and a capacitor supplied by direct current (DC) voltage. The capacitors are schematically indicated in Fig. 4 by lumped elements 36 and 37, respectively, which are mounted on the wrapped around ground plane 22. Bond wires 38 and 39, respectively, each constitute the inductance of the respective RF choke comprising a bias network for the field effect transistor device 25.

At the input side of the first amplifier stage there is formed a center bonding pad 40 isolated from the wrapped around ground plane 32. This bonding pad represents an input matching impedance designated in Fig.5 by reference numeral 40'. A relatively large shunt capacitor 41 is mounted onto this center bonding pad 40. This capacitor 41 is connected to the adjacent surface of the ground plane 22 by bond wires 42. This circuit is represented in the equivalent circuit diagram of Fig. 5 by the capacitor 41' and a parasitic inductor 42' connected between the output of the matching impedance 40' and the grounded line 32'.

In addition, a lumped series inductor connecting the center bonding pad 40 to the gate bonding pad 33 is formed of a coiled bond wire 43. This inductance is represented in Fig. 5 by the gate inductance 43'. A second shunt capacitor 44 is mounted onto the drain bonding pad 34 and connected to the ground plane 32 by bond wires 45. Correspondingly, this circuit is represented in the equivalent circuit diagram of Fig. 5 by the series connection of a capacitor 32' and an inductance 33' arranged between the drain of the field effect transistor device 35' and the grounded line 32'.

0117434

The general design of the second amplifier stage is similar. A second field effect transistor device 55 being flip-mounted onto the substrate 31 is connected to the ground plane 3 and the gate and drain bonding pads 53 and 54, respectively. Two corresponding RF chokes each include a further capacitor 56 and 57 mounted onto the ground plane. Each capacitor is connected by further bond wires 58, 59 to the gate bonding pad 53 and the drain bonding pad 54, respectively. The drain bonding pad 54 and an output matching network 60' implemented by a laterally extending center pad 60 are commonly formed of one lead structure. Similarly the gate bonding pad 53 by means of a lead 61 laterally projecting in the direction of the first amplifier stage constitutes an input matching resistor 61'. In this area a further capacitor 62 is mounted onto the lead and is connected by bonded wires 63 to the output pad of the first amplifier stage.

From the detailed description of the first amplifier stage in conjunction with Fig. 4 and 5 it is evident that the second amplifier stage is represented in the equivalent circuit diagram of Fig. 5 by elements designated by reference numerals 55' through 63'. Each of these elements can be clearly identified by comparison to corresponding reference numerals shown in Fig. 4. Further detailed description is therefore deemed not necessary.

Thus having described two embodiments of a hybrid circuit constructed in accordance with the present invention, it will be evident to those skilled in the art that different kinds of subsystems, such as transmitters, receivers, filters, etc., can be designed based upon the same design concept. In any case, in a production mode a large sheet of a beryllium oxide substrate with slots punched through can be thin-film metalized. Photolithography can be used to etch circuits onto this board. The circuit boards

can be laser-scribed into separate pieces and the punched slots will form the wrap around metalized sides to allow for a top surface of the ground plane. Various circuit elements and active transistor devices may then be mounted onto this board. These devices can be fully tested for its RF characteristics before soldering into a hermetic package, not shown, or having a ceramic lid mounted.

There has thus been shown and described a novel microwave hybrid circuit arrangement which fulfills all the objects and advantages sought therefor. Many changes, modifications, variations and other uses and applications of this subject invention will, however, become apparent to those skilled in the art after considering the specification and the accompanying drawings which disclose preferred embodiments thereof. All such changes, modifications, variations and other uses and applications which do not depart from the spirit and scope of the invention are deemed to be covered by the invention which is limited only by the claims which follow.

0117434

E

WHAT IS CLAIMED IS:

1.      A hybrid micro-wave subsystem for direct connection to a microwave transmission line, comprising:

    (1)  a dielectric substrate of high thermal
         conductivity and having plane bottom
         and top surfaces;

    (2)  a thin-film metalized ground plane covering said
         bottom surface and being wrapped around the
         substrate leaving a center area on the top
         surface exposed;

    (3)  electrode bonding pads mounted onto said
         top surface and arranged within said open
         center area;

    (4)  a transistor device having coplanar electrodes
         and being flip-mounted onto the top surface in
         allignment with said electrode bonding pads;

    (5)  a thin-film matching network arranged in said
         open center area and being connected to
         respective ones of said bonding pads; and

    (6)  a discrete component mounted onto the top
         surface for connection with the transistor
         device.

2.      The hybrid microwave subsystem as recited in claim 1, wherein the transistor device is a gallium arsenide field effect transistor.

3.       The hybrid microwave subsystem as recited in claim 2, wherein the substrate is composed of beryllium oxide forming together with the metalized ground plane a heat sink for the field effect transistor having an index of thermal expansion of substantially the same value as that of the substrate.

4.       The hybrid microwave subsystem as recited in claim 3, wherein the matching network and the respective bonding pad facing the same are commonly formed of a single bonding area.

5.       The hybrid microwave subsystem as recited in claim 3, wherein the matching network and the bonding pad facing the same are separated from each other by a gap and connected by means of a bond wire being coiled to form a series inductor.

6.       The hybrid microwave subsystem as recited in claim 1, wherein the discrete component having two leads is directly mounted onto the thin-film matching network for electrical connection by the first lead and is connected to the metalized ground plane by the second lead.

7.       The hybrid microwave subsystem as recited in claim 1, wherein the discrete component having two leads is mounted onto the metalized ground plane for directly grounding one lead and is connected to a respective bonding pad by the other lead.

8.       The hybrid microwave subsystem as recited in claim 7, wherein the discrete component comprises a voltage controlled bias network for the transistor device and a bond wire connecting the discrete component to a respective bonding pad.

9.      The hybrid microwave subsystem as recited in claim 8, wherein the bias network includes a small capacitor directly mounted onto the ground plane and a radio frequency choke by means of the correspondingly coiled bond wire.      -

10.      The hybrid microwave subsystem as recited in claim 6, wherein the discrete component is a capacitor and bond wires are provided to connect this capacitor to the ground plane, whereby this network forms a shunt capacitor.

11.      The hybrid microwave subsystem as recited in claim 6, comprising a cascaded arrangement of single stages, each including a transistor device, respective bonding pads, matching networks and discrete components.

12.      The hybrid microwave subsystem as recited in claim 11, wherein one discrete component forming a series capacitor is mounted by one lead onto a matching network of one stage and a bonded wire connects the other lead of this series capacitor to the adjacent matching network of the neighboring stage.

# FIG 1

FET 5
(GaAs)

DRAIN 51

SOURCE 52

GATE 53

21

UM GRUNDPLATE 2
GEWICKELT

3

6

4

SUBSTRAT 1
(BeO)

## FIG 2

## FIG 3

## FIG 4

## FIG 5

European Patent Office

**EUROPEAN SEARCH REPORT**

0117434
Application number

EP 84 10 0776

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | EP-A-0 015 709 (FUJITSU)<br>* Page 9, lines 4-18 *<br><br>--- | 1,2 | H 01 L 23/56<br>H 01 L 25/00 |
| A | US-A-3 683 241 (DUNCAN)<br>* Column 3, lines 4-27 *<br><br>----- | 1,3 | |

TECHNICAL FIELDS SEARCHED (Int. Cl. ³)

H 01 L 23/48
H 01 L 23/56
H 01 L 25/00
H 01 P 3/08
H 01 P 5/00

The present search report has been drawn up for all claims

| Place of search | Date of completion of the search | Examiner |
|---|---|---|
| BERLIN | 04-04-1984 | GIBBS C.S. |